# FASCICULE DE BREVET EUROPEEN

(11) **EP 2 965 346 B1**
(45) Date de publication et mention de la délivrance du brevet: **04.03.2020**
(21) Numéro de dépôt: 14713216.1
(22) Date de dépôt: 05.03.2014
(51) Int. Cl.: H01L 21/18

(54) **PROCÉDÉ DE RÉALISATION D'UN COLLAGE DIRECT MÉTALLIQUE CONDUCTEUR**
VERFAHREN ZUR HERSTELLUNG EINER LEITFÄHIGEN DIREKTMETALLVERBINDUNG
METHOD FOR PRODUCING CONDUCTIVE DIRECT METAL BONDING

(30) Priorité: 05.03.2013 FR 1351976
(43) Date de publication de la demande: 13.01.2016
(73) Titulaire: Commissariat à l'Énergie Atomique et aux Énergies Alternatives, 75015 Paris (FR)
(72) Inventeur: GONDCHARTON, Paul, F-38100 Grenoble (FR); BENAISSA, Lamine, F-91300 Massy (FR); IMBERT, Bruno, F-38000 Grenoble (FR)
(74) Mandataire: Delorme, Nicolas
(86) Numéro de dépôt international: PCT/FR2014/050504
(87) Numéro de publication internationale: WO 2014/135802

(56) Documents cités:
- US-A1- 2005 003 650
- US-A1- 2009 183 825
- US-A1- 2010 190 298
- AKITSU SHIGETOU ET AL: "Modified diffusion bonding for both Cu and SiO2 at 150 Â DEG C in ambient air", ELECTRONIC COMPONENTS AND TECHNOLOGY CONFERENCE (ECTC), 2010 PROCEEDINGS 60TH, IEEE, PISCATAWAY, NJ, USA, 1 juin 2010 (2010-06-01), pages 872-877, XP031693923, ISBN: 978-1-4244-6410-4

## Description

La présente invention concerne un procédé de réalisation d'un collage direct métallique conducteur entre deux substrats semi-conducteurs. L'invention concerne également une structure présentant deux substrats semi-conducteurs assemblés par un collage direct métallique conducteur.

Plusieurs techniques connues de collage conducteur susceptibles d'assembler des substrats mettent en contact direct des métaux déposés sur une face des substrats, sans introduire de composés intermédiaires, tel qu'un adhésif, de la glue.., au niveau de l'interface.

A titre d'exemple, le procédé de collage direct non thermocompressif du cuivre consiste en la mise en contact, en général à température ambiante, de surfaces lisses, à savoir des surfaces présentant une rugosité inférieure ou égale à 0,5 nm RMS, hydrophiles (c'est-à dire présentant un angle de goutte à l'eau typiquement inférieur ou égal à 20°) et exemptes de contamination. Un recuit peut être ensuite appliqué à la structure afin de renforcer la qualité du collage. A l'issue de ce traitement thermique, l'interface de collage apparaît reconstruite et présente des contacts cuivre/cuivre permettant d'une part la conduction électrique et d'autre part une bonne résistance mécanique à l'amincissement de l'un au moins des substrats composant la structure.

Cette technique présente l'inconvénient d'être dépendante de l'état des surfaces avant collage. Les étapes critiques de ce procédé sont donc le polissage mécano-chimique et l'activation des surfaces réalisées sur les couches métalliques déposées avant collage. Or, d'une part, la maîtrise de tels procédés varie d'un métal à l'autre et d'autre part, une contrainte temporelle d'enchaînement des étapes de préparation et de collage est nécessaire à la réussite de tels assemblages.

D'autres techniques de collage métallique de couches déposées sont connues comme les procédés de collage de cuivre assisté par thermocompression. Dans cette technique, un apport d'énergie supplémentaire est fourni au moment du collage des substrats sous forme calorifique et mécanique par l'application d'une pression de part et d'autre de l'assemblage.

Cette technique a pour avantage de limiter les contraintes en termes de préparations de surface préalables et tout particulièrement en terme de lissage (faisabilité montrée jusqu'à 8,6 nm RMS). Cependant, les températures de procédé conduisant à la reconstruction de l'interface de collage sont supérieures ou égales à 350°C et peuvent endommager des composants présents sur la structure.

Il est connu du document US2005/003650 des arrangements tridimensionnels de substrats empilés avec des liaisons fiables et des protections inter-substrats.

Il est également connu du document US2009/183825 un procédé de formation d'un corps collé comprenant un premier élément de base, un second élément de base et un premier film de collage et un second film de collage placés entre le premier élément de base et le second élément de base. Le premier film de collage et le second film de collage sont constitués de cuivre et d'un composant organique, la quantité de cuivre contenue dans chacun du premier film de collage et du second film de collage est de 80% en atomes ou plus, mais inférieure à 90% en atomes (rapport atomique). Le procédé consiste à former le premier film de collage sur le premier élément de base en utilisant un procédé de formation de film chimique en phase vapeur; à former le second film de collage sur le second élément de base en utilisant un procédé de formation de film chimique en phase vapeur; à amener le premier film de collage formé sur le premier élément de base en contact avec le deuxième film de collage formé sur le deuxième élément de base de sorte que le premier film de collage fasse face au deuxième film de collage; et à appliquer une force de compression sur le premier élément de base et le deuxième élément de base de sorte que le premier film de collage et le deuxième film de collage soient collés l'un à l'autre afin d'obtenir ainsi le corps collé. Les deux éléments de base peuvent être collés de manière ferme et efficace avec une précision dimensionnelle élevée à basse température, et les deux éléments de base peuvent être efficacement séparés (décollés) l'un de l'autre après l'utilisation du corps collé.

Le principal inconvénient mis en évidence par l'état de l'art relatif à cette technique est la présence résiduelle après collage de défauts au niveau de l'interface qui apparaissent sous la forme de vides (au sens de manque de matière solide) limités par des joints de grains.

Un des buts de l'invention consiste à pallier au moins un des inconvénients précités. A cet effet, l'invention propose un procédé de réalisation d'un collage direct métallique conducteur entre deux substrats de matériaux semi-conducteurs, selon la revendication 1.

En d'autres termes, l'oxyde métallique est en contact direct avec le métal de la première couche métallique et le métal de la deuxième couche métallique. Ainsi, lors de la mise en œuvre du procédé, l'oxyde métallique formé à l'interface de collage permet de générer des zones de contact métal/oxyde/métal au niveau des cavités, renforçant ainsi l'énergie de collage au niveau de l'interface. Il est alors possible d'appliquer des opérations mécaniques sur l'un ou les deux substrats notamment un amincissement mécanique de l'un des substrats sans décollement de l'interface de collage. Par ailleurs, lorsque l'oxyde métallique formé est conducteur ou semi-conducteur, le collage obtenu présente une meilleure conduction électrique que celle obtenue par un collage direct conventionnel entre deux métaux aux rugosités considérées. Ainsi, les composants formés sur la structure montrent des performances améliorées.

Cette technique a pour avantage de limiter les contraintes en termes de préparations de surface par comparaison avec une technique de collage directe conventionnelle, notamment en termes de lissage et de contamination. Ceci évite de consommer une très grande quantité de matériau avant d'atteindre la rugosité souhaitée. Ainsi, avec cette méthode et sans thermocompression, le niveau de rugosité pour obtenir un collage est élevé à 0,7 nm RMS contre 0,5 sans oxydation à l'interface de collage. Il est à noter que dans le présent document, toutes les valeurs de rugosité RMS sont des mesures AFM pour des champs de 20^{∗}20 micromètres. De la même façon, le procédé de l'invention permet de diminuer l'exigence sur les propriétés hydrophiles de la surface, très importante en cas de collage direct sans thermocompression. De ce fait, la contrainte temporelle entre l'étape de préparation des surfaces des couches métalliques avant collage et le collage direct lui-même est moins importante. Il est en effet possible de laisser les couches métalliques sous atmosphère contrôlée, par exemple sous vide ou sous atmosphère d'azote, avant de procéder à la mise en contact des surfaces sans craindre une contamination ou un changement de l'hydrophilie de la surface. On peut même en cas de collage direct à chaud les laisser à l'air avant mise en contact.

De préférence, l'étape d) d'immersion est réalisée pendant une durée comprise environ entre 30 minutes et plusieurs heures de sorte à permettre la pénétration du fluide oxydant et la croissance de l'oxyde métallique dans les cavités. Laisser l'interface immergée pendant l'oxydation permet d'éviter que le fluide ne se retire permettant ainsi une oxydation homogène en bord et au centre des substrats.

Avantageusement, le procédé comprend entre l'étape b) et l'étape d) une étape c) d'application d'un budget thermique de recuit de collage. Par budget thermique, on entend l'application d'une température pendant un certain temps. Ce budget thermique sert à renforcer l'énergie de collage.

De préférence, l'application d'un budget thermique selon l'étape c) comprend en outre une étape c1) d'application d'une pression de part et d'autre de l'interface de collage. Cette étape, consistant en la combinaison de c) et de c1) est une thermocompression et permet d'améliorer la qualité de l'interface de collage et la qualité des ponts de matière métalliques formés avant de procéder à l'oxydation des cavités résiduelles. Elle permet d'assembler des surfaces présentant des rugosités plus importantes qu'en l'absence de thermocompression. Il est par exemple possible d'obtenir un collage direct avec des surfaces présentant une rugosité jusqu'à 50 nm RMS dans le cadre de l'invention avec oxydation et thermocompression contre une rugosité de moins de 10nm RMS avec thermocompression sans oxydation. La pression appliquée dépend de l'état de surfaces à coller (notamment rugosité RMS et hydrophilie) elle varie typiquement entre 1 et 5MPa. Il sera alors possible d'obtenir un collage entre deux surfaces qui délimitent des cavités d'une dimension jusqu'à environ 100 nm dans une direction sensiblement perpendiculaire à l'interface de collage.

Selon une possibilité, le procédé comprend avant l'étape b) de mise en contact, une étape i) consistant à lisser la surface des première et deuxième couches métalliques, notamment jusqu'à obtenir une rugosité RMS comprise environ entre 0.1 et 0,7 nanomètres. Cette préparation de surface va rendre possible le collage direct sans thermocompression. Le bénéfice tiré de l'oxydation contrôlée du métal lors de l'immersion de l'étape d) permet de réaliser en amont un collage direct moins dépendant de l'état de surface avant collage que pour un collage direct conventionnel où une rugosité inférieure à 0.5 nanomètre RMS est nécessaire. Pour des collages avec thermocompression, on pourra s'affranchir de cette étape de lissage et ce jusqu'à des rugosités RMS de l'ordre de 50 nm.

Avantageusement, l'étape d) d'immersion comprend le chauffage du fluide oxydant, notamment à une température comprise environ entre 10°C et 100°C. Cette température permet d'accélérer le processus d'oxydation du métal.

Selon une disposition, le procédé comprend après l'étape d) d'immersion et d'oxydation, une étape e) d'application d'un traitement thermique de renforcement du collage. Cette étape permet de renforcer encore l'énergie du collage. Du fait de l'étape d) d'immersion, il est possible de diminuer le budget thermique du recuit de collage de l'étape e) (c'est-à-dire la température et/ou le temps du recuit) pour l'obtention d'une même énergie de collage. Réduire la température peut permettre d'éviter d'endommager d'éventuels composants présents sur les substrats.

Selon une disposition, le procédé comprend avant l'étape a) de fourniture d'un premier substrat et d'un deuxième substrat, une étape consistant à déposer par CVD (Chemical Vapor Déposition) la première couche métallique et la deuxième couche métallique respectivement sur ladite surface du premier substrat et sur ladite surface du deuxième substrat.

Selon une possibilité, l'étape de dépôt est réalisée jusqu'à atteindre une épaisseur pour la première couche métallique et pour la deuxième couche métallique comprise entre 20 et 5000 nanomètres et de préférence une épaisseur comprise entre 500 et 1000 nanomètres.

De préférence, la première couche métallique et la deuxième couche métallique sont déposées sur les substrats dotés au préalable d'une couche barrière présentant une épaisseur de quelques dizaines de nanomètres, notamment formée de TiN. Cette couche sert à former une barrière à la diffusion des espèces métalliques des couches métalliques dans les substrats, notamment lors des étapes de recuit. Elle peut également servir de couche d'accroche pour le dépôt des couches métalliques.

Selon une possibilité, les premier et deuxième substrats sont choisis parmi les matériaux semi-conducteurs compris parmi le silicium, le SiC, le germanium, les alliages d'éléments III/V tels que le AsGa, l'InP, l'InGaN, l'AlGaN.

Selon une variante, le premier substrat comprend un matériau semi-conducteur différent de celui du deuxième substrat.

Avantageusement, le métal de la première couche métallique et le métal de la deuxième couche métallique présentent une bonne conductivité électrique, et génèrent un oxyde plus volumineux que le métal non oxydé de sorte à facilement combler les cavités de l'interface de collage. Par ailleurs, l'utilisation de certains de ces métaux est avantageuse en ce qu'ils peuvent générer un oxyde au moins partiellement électriquement conducteur, en ce qu'ils sont résistants à la corrosion et présentent un coefficient de dilatation thermique CTE proche de celui des matériaux semi-conducteurs les plus couramment utilisés dans l'industrie.

Selon une disposition, le métal de la première couche métallique est identique au métal de la deuxième couche métallique. Ceci permet la formation concomitante d'une seule nature d'oxyde métallique à partir des première et deuxième couches métalliques.

Les zones de contact générées à l'interface de collage comprennent alors une seule nature d'oxyde métallique formant des zones de contact direct avec la première couche métallique et avec la deuxième couche métallique, ce qui permet une bonne qualité de contact métal/oxyde/métal, conducteur électrique.

Selon une variante de réalisation, le métal de la première couche métallique est différent du métal de la deuxième couche métallique de sorte que le fluide oxydant génère un oxyde métallique comprenant deux natures d'oxyde. Une première nature d'oxyde est générée par l'oxydation du métal de la première couche métallique et une deuxième nature d'oxyde est générée par l'oxydation du métal de la deuxième couche métallique. Ainsi les zones de contact sont formées par l'oxyde métallique comprenant deux natures d'oxyde, en contact direct entre elles, la première nature étant également en contact direct respectivement avec la première couche métallique et la deuxième nature étant en contact direct respectivement avec la deuxième couche métallique.

Selon une autre disposition, l'application du budget thermique selon l'étape c) est réalisée à une température comprise entre 30°C et 400°C et de préférence à une température inférieure ou égale à 250°C et de préférence encore à une température comprise entre 50°C et 200°C, sur une durée comprise entre quelques dizaines de minutes et plusieurs heures. Ces températures relativement basses par comparaison avec les températures de thermocompression conventionnelle limitent la dégradation d'éventuels composants présents sur les substrats.

La première couche métallique recouvre la totalité de ladite surface du premier substrat et la deuxième couche métallique recouvre la totalité de ladite surface du deuxième substrat. Ainsi, le fluide oxydant peut circuler entre les cavités présentes à l'interface entre la première couche et la deuxième couche métallique recouvrant la totalité desdites surfaces du premier substrat et du deuxième substrat.

Selon un deuxième aspect, l'invention propose une structure présentant une conductivité électrique verticale et comprenant un empilement tel que défini à la revendication 8.

Avantageusement, au moins 50% des cavités partiellement comblées par l'oxyde métallique présentent une dimension inférieure ou égale à 50 nanomètres, de préférence une dimension inférieure ou égale à 25nm et de préférence encore une dimension inférieure ou égale à 10 nm.

De préférence, les cavités partiellement comblées par l'oxyde métallique présentent une dimension inférieure ou égale 10 nanomètres.

La résistance mécanique de l'interface de collage est ainsi renforcée par la présence des zones de contact de dimensions plus importantes. Par ailleurs, la conductivité électrique de ce type de collage direct selon l'invention est améliorée par rapport à celle obtenu avec un collage direct traditionnel du fait de la présence de l'oxyde métallique pouvant être conducteur ou semi-conducteur.

D'autres aspects, buts et avantages de la présente invention apparaîtront mieux à la lecture de la description suivante d'un mode de réalisation de celle-ci, donnée à titre d'exemples non limitatifs et fait en référence aux dessins annexés. Les figures ne respectent pas nécessairement l'échelle de tous les éléments représentés de sorte à améliorer leur lisibilité. Dans la suite de la description, par souci de simplification, des éléments identiques, similaires ou équivalents des différentes formes de réalisation portent les mêmes références numériques.
- Les figures 1 à 4 illustrent un mode de réalisation du procédé selon l'invention.
- La figure 5 illustre une structure préparée pour une application future.

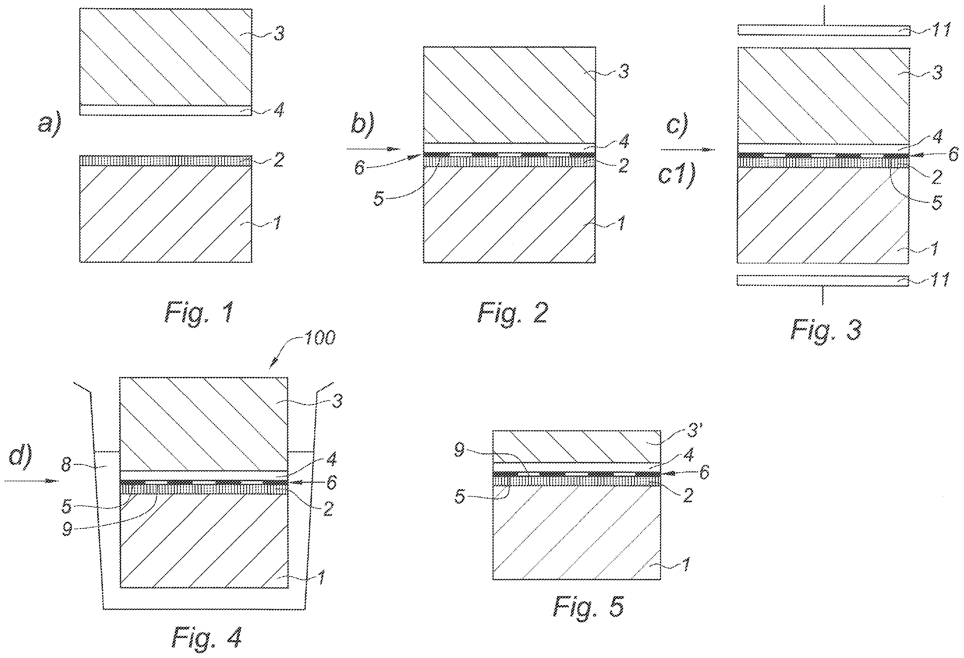

La figure 1 représente l'étape a) du procédé consistant à fournir un premier substrat 1 de silicium, sur une surface duquel a été déposée une première couche métallique 2 de cuivre, et un deuxième substrat 3 de silicium sur une face duquel a été déposé une deuxième couche métallique 4 de cuivre. La première couche métallique 2 et la deuxième couche métallique 4 sont déposées notamment par CVD de sorte à couvrir la totalité desdites surfaces des substrats 1,3 respectifs par un dépôt communément appelé 'pleine plaque'. Selon une disposition non illustrée, les surfaces des substrats ont été dotées au préalable d'une couche d'oxyde de silicium thermique et d'une couche barrière de 60 nanomètres de TiN déposé par CVD (acronyme anglais de Chemical Vapor Déposition) de sorte à favoriser la tenue des couches métalliques 2,4 sur les substrats 1,3. Les première et deuxième couches métalliques 2,4 de cuivre sont ensuite déposées avec une épaisseur comprise entre 20 et 5000 nanomètres directement sur la couche barrière par la méthode PVD (acronyme anglais de Pressure Vapor Déposition).

Les première et deuxième couches métalliques 2,4 ainsi formées présentent pour une épaisseur de 1 micromètre une rugosité RMS d'environ 5,6 nanomètres (sur un champ de 20^{∗}20 micromètres) et une hydrophilie correspondant à un angle de goutte à l'eau d'environ 37°.

Selon une disposition non illustrée, l'invention peut être mise en œuvre avec une première couche métallique 2 et une deuxième couche métallique 4 comprenant d'autres métaux que le cuivre, tels que le molybdène, le tungstène et leurs alliages. Par ailleurs, le métal de la première couche métallique 2 peut être différent du métal de la deuxième couche métallique 4.

La figure 2 illustre la mise en contact des première et deuxième couches métalliques 2,4 de cuivre selon l'étape b) du procédé réalisant un collage direct entre les surfaces présentant les caractéristiques susmentionnées. Ce collage permet la génération de ponts de matière 5 métalliques cuivre/cuivre à l'interface de collage 6 entre la première couche métallique 2 et la deuxième couche métallique 4. Ces ponts de matière 5 sont symboliquement représentés sur la figure 2 par des tirets gras noirs à l'interface de collage 6. L'interface de collage 6 comprend également des cavités (non illustrées) séparant les ponts de matière 5. Ces cavités reliées fluidiquement entre elles, proviennent de défauts ou vides de matière solide, formés lors du collage direct.

Puis, comme illustré à la figure 3, le collage peut être renforcé par thermocompression (étapes c et c1). Un budget thermique de recuit de collage est effectué à 200°C pendant 1 heure associé à l'application d'une pression d'environ 1.91 MPa de part et d'autre de l'interface de collage 6. Cette pression est de préférence appliquée sur l'ensemble de la surface des substrats collés par l'intermédiaire de deux pistons 11 avec une force de 15kN lorsque les substrats présentent un diamètre d'environ 10 cm. Une pression homogène uniformément répartie est ainsi exercée de part et d'autre de l'interface de collage 6. Cette étape de thermocompression peut être réalisée sous vide primaire ou secondaire.

La thermocompression permet d'augmenter l'énergie de collage entre les première et deuxième couches métalliques 2,4. Les ponts de matière 5 Cu/Cu sont illustrés par des tirets encore plus épais à l'interface de collage 6 symbolisant une force de collage plus importante à l'issue des étapes c) et c1). La température du budget thermique peut varier selon les propriétés des substrats à coller, notamment en termes de rugosité et d'hydrophilie des surfaces. Par exemple, la température peut être comprise entre 30°C et 400°C et de préférence la température est inférieure ou égale à 250°C et de préférence encore la température est comprise entre 50°C et 200°C, sur une durée comprise entre quelques dizaines de minutes et plusieurs heures. La pression appliquée peut également varier, typiquement entre 1 et 5MPa.

Cette étape de thermocompression illustrée à la figure 3 est facultative. Si certaines conditions sont rassemblées au niveau des surfaces à assembler notamment en termes de rugosité RMS (inférieure à typiquement 0.7nm) et d'hydrophilie, la simple mise en contact des substrats peut suffire à assurer leur adhésion (le procédé correspond alors aux étapes illustrées aux figures 1, 2 et 4). Une étape préliminaire i) de préparation de surface est en général nécessaire dans ce cas, notamment de lissage pouvant être obtenu par polissage mécano-chimique.

Enfin selon l'étape d) du procédé illustrée à la figure 4, l'interface de collage 6 est immergée dans un fluide oxydant 8, tel que de l'eau liquide à 22°C, pendant une durée d'environ 12 heures. Cette immersion permet la propagation du fluide 8 au niveau des cavités sur toute l'interface de collage 6. Cette phase est rapide (de 10 secondes à une minute environ). Elle provoque également sur cette durée, l'oxydation d'au moins une partie des portions de la première couche métallique 2 et de la deuxième couche métallique 4 délimitant les cavités en oxyde de cuivre Cu₂O. Cet oxyde métallique ainsi généré permet de combler au moins en partie les cavités. Le Cu₂O présente un effet un volume plus important que le cuivre non oxydé de sorte que la croissance de la phase d'oxyde de cuivre en surface des cavités permet de les remplir. L'oxyde de cuivre ferme ainsi les défauts. L'interface de collage 6 obtenue après oxydation comprend des ponts de matière 5 Cu/Cu, des zones de contact 9 Cu/Cu₂O/Cu (symbolisées par des traits gras gris 9 entre les traits noirs gras symbolisant les ponts de matière 5 sur la figure 4) ainsi que des cavités résiduelles dont la plus grande dimension est inférieure ou égale à 10 nanomètres. Une telle interface 6, dotée de ponts de matière 5 métalliques et de zones de contact 9 en oxyde de cuivre semi-conducteur, présente une énergie de collage renforcée et une conductivité électrique verticale optimisée par rapport à une interface de collage 6 obtenue par un collage direct conventionnel.

Dans la variante de réalisation où la première couche métallique 2 est formée d'un métal différent de celui de la deuxième couche métallique 4, l'oxyde métallique peut comprendre deux natures d'oxyde différentes, selon les cinétiques d'oxydation des deux métaux. Les zones de contact 9 sont alors formées d'oxyde de deux métaux différents qui relie des portions de la première couche métallique 2 et des portions de la deuxième couche métallique 4. Ainsi, l'interface de collage 6 est mécaniquement renforcée et la conductivité verticale électrique est améliorée selon la conductivité des deux natures d'oxyde.

Par ailleurs, le fluide oxydant 8 peut être constitué d'un liquide oxydant d'une autre nature que l'eau, choisi selon la nature du métal à oxyder. Par ailleurs, le fluide oxydant 8 peut être chauffé entre environ 10°C à 100°C pendant l'immersion, de sorte à augmenter ou diminuer la vitesse d'oxydation du métal.

Selon une autre possibilité de réalisation non illustrée, il est possible après l'étape d) d'immersion de réaliser une étape e) d'application d'un traitement thermique de renforcement du collage comme pour les collages directs traditionnels.

Le procédé de réalisation conduit ainsi à la fabrication d'une structure 100 comportant un empilement comprenant successivement un premier substrat 1 de silicium, une première couche métallique 2 de Cu, une deuxième couche métallique 4 de Cu collée directement à la première couche métallique 2 par collage direct, de sorte à former une interface de collage 6 électriquement conductrice, et un deuxième substrat 3 de silicium. L'interface de collage 6 comprend des cavités comblées au moins en partie par un oxyde de cuivre, des ponts de matière 5 Cu/Cu et des zones de contact 9 Cu/Oxyde de cuivre /cuivre. Les cavités résiduelles présentent une dimension de 10 nanomètres au plus. De part la présence des zones de contacts 9 Cu/Cu₂O/Cu à l'interface de collage 6 il est possible d'effectuer un amincissement mécanique de type 'grinding' ou rectification à partir de la face arrière exposée de l'un des substrats 1,3 sans provoquer de décollement à l'interface de collage 6 (figure 5, le substrat 3 a été aminci en substrat 3').

Ainsi, la présente invention propose un procédé de réalisation d'un collage direct métallique conducteur entre deux substrats 1,3 semi-conducteurs permettant de limiter les contraintes de planarisation et d'hydrophilie des surfaces à coller, tout en assurant une forte énergie de collage, une très bonne conductivité électrique et une mise en œuvre peu coûteuse.

Il va de soi que l'invention n'est pas limitée aux variantes de réalisation décrites ci-dessus à titre d'exemple mais qu'elle comprend tous les équivalents techniques et les variantes des moyens décrits ainsi que leurs combinaisons.

## Revendications

1. Procédé de réalisation d'un collage direct métallique conducteur entre deux substrats (1,3) de matériaux semi-conducteurs, comprenant les étapes consistant à :
- a) Fournir un premier substrat (1) dont la totalité d'une surface est recouverte par une première couche métallique (2) et un deuxième substrat (3) dont la totalité d'une surface est recouverte par une deuxième couche métallique (4), la rugosité de la première couche métallique (2) et la rugosité de la deuxième couche métallique (4) métallique étant inférieure à 50 nm RMS, le métal de la première couche métallique (2) et le métal de la deuxième couche métallique (4) sont choisis parmi le cuivre, le molybdène, le tungstène et leurs alliages,
- b) Mettre en contact direct la première couche métallique (2) et la deuxième couche métallique (4) de sorte à former une interface de collage (6) comprenant des ponts de matière (5) métalliques entre la première couche métallique (2) et la deuxième couche métallique (4), les ponts de matière (5) étant espacés par des cavités reliées fluidiquement entre elles,
- d) Après l'étape b), immerger l'interface de collage (6) dans un liquide oxydant (8) choisi parmi l'eau liquide (H2O) et l'eau oxygénée (H2O2), de sorte à oxyder au moins en partie des portions de la première couche métallique (2) et des portions de la deuxième couche métallique (4) délimitant les cavités, cette oxydation générant un oxyde métallique comblant au moins en partie les cavités, l'oxyde métallique formant des zones de contact (9) entre les portions de la première couche métallique (2) et de la deuxième couche métallique (4) délimitant les cavités.

2. Procédé selon la revendication 1, **caractérisé en ce que** l'étape d) d'immersion est réalisée pendant une durée comprise environ entre 30 minutes et plusieurs heures de sorte à permettre la pénétration du fluide oxydant (8) et la croissance de l'oxyde métallique dans les cavités.

3. Procédé selon l'une des revendications 1 à 2, **caractérisé en ce que** le procédé comprend entre les étapes b) et d) une étape d'application c) d'un budget thermique de recuit de collage.

4. Procédé selon la revendication 3, **caractérisé en ce que** l'application du budget thermique selon l'étape c) comprend en outre une étape c1) d'application d'une pression de part et d'autre de l'interface de collage (6).

5. Procédé selon l'une des revendications 1 à 4, **caractérisé en ce que** l'étape d) d'immersion comprend le chauffage du fluide oxydant (8) notamment à une température comprise environ entre 10°C et 100°C.

6. Procédé selon l'une des revendications 1 à 5, **caractérisé en ce que** le procédé comprend après l'étape d) une étape e) d'application d'un traitement thermique de renforcement du collage.

7. Procédé selon l'une des revendications 3 à 6, **caractérisé en ce que** l'application du budget thermique selon l'étape c) est réalisée à une température comprise entre 30°C et 400°C et de préférence à une température inférieure ou égale à 250°C et de préférence encore à une température comprise entre 50°C et 200°C, sur une durée comprise entre quelques dizaines de minutes et plusieurs heures.

8. Structure (100) présentant une conductivité électrique verticale et comprenant un empilement comportant successivement
- un premier substrat (1) d'un matériau semi-conducteur,
- une première couche métallique (2),
- une deuxième couche métallique (4) collée directement à la première couche métallique (2) par collage direct de sorte à former une interface de collage (6) électriquement conductrice, et
- un deuxième substrat (3) d'un matériau semi-conducteur,
la première couche métallique (2) recouvrant la totalité d'une surface du premier substrat (1), la deuxième couche métallique (4) recouvrant la totalité d'une surface du deuxième substrat (3), la rugosité de la première couche métallique (2) et la rugosité de la deuxième couche métallique (4) étant inférieures à 50 nm RMS et le métal de la première couche métallique (2) et le métal de la deuxième couche métallique (4) étant choisis parmi le cuivre, le molybdène, le tungstène et leurs alliages, et
l'interface de collage (6) comprenant
des ponts de matière (5) métalliques entre la première couche métallique (2) et la deuxième couche métallique (4), les ponts de matière (5) étant espacés par des cavités,
un oxyde métallique, généré par l'oxydation des portions de la première couche métallique (2) et de la deuxième couche métallique (4) délimitant les cavités, comblant au moins en partie les cavités, l'oxyde métallique formant des zones de contact (9) entre les portions de la première couche métallique (2) et de la deuxième couche métallique (4) délimitant les cavités.

9. Structure (100) selon la revendication 8, **caractérisée en ce qu'**au moins 50% des cavités partiellement comblées par l'oxyde métallique présentent une dimension inférieure ou égale à 50 nanomètres.

## Patentansprüche

1. Verfahren zur Herstellung einer leitfähigen Direktmetallverbindung zwischen zwei Substraten (1, 3) aus halbleitfähigen Materialien, umfassend die Schritte, die aus Folgendem bestehen:
- a) Liefern eines ersten Substrats (1), bei dem die Gesamtheit einer Fläche von einer ersten Metallschicht (2) bedeckt ist, und eines zweiten Substrats (3), bei dem die Gesamtheit einer Fläche von einer zweiten Metallschicht (4) bedeckt ist, wobei die Rauigkeit der ersten Metallschicht (2) und die Rauigkeit der zweiten Metallschicht (4) kleiner als 50 nm RMS ist, wobei das Metall der ersten Metallschicht (2) und das Metall der zweiten Metallschicht (4) ausgewählt ist aus Kupfer, Molybdän, Wolfram und ihren Legierungen,
- b) Direktes In-Kontakt-Bringen der ersten Metallschicht (2) und der zweiten Metallschicht (4), um eine erste Verbindungsschnittstelle (6) zu bilden, umfassend Metallmaterialbrücken (5) zwischen der ersten Metallschicht (2) und der zweiten Metallschicht (4), wobei die Materialbrücken (5) durch Hohlräume beabstandet sind, die fluidisch miteinander verbunden sind,
- d) nach Schritt b) Eintauchen der Verbindungsschnittstelle (6) in eine oxidierende Flüssigkeit (8), ausgewählt aus flüssigem Wasser (H₂O) und Wasserstoffperoxid (H₂O₂), um mindestens teilweise Abschnitte der ersten Metallschicht (2) und Abschnitte der zweiten Metallschicht (4), die die Hohlräume begrenzen, zu oxidieren, wobei diese Oxidation ein Metalloxid erzeugt, das mindestens teilweise die Hohlräume ausfüllt, wobei das Metalloxid Kontaktbereiche (9) zwischen den Abschnitten der ersten Metallschicht (2) und der zweiten Metallschicht (4) bildet, die die Hohlräume begrenzen, bildet.

2. Verfahren nach Anspruch 1, **dadurch gekennzeichnet, dass** Schritt d) des Eintauchens während einer Dauer durchgeführt wird, die zwischen ungefähr 30 Minuten und mehreren Stunden liegt, um das Eindringen des oxidierenden Fluids (8) und das Wachstum des Metalloxids in den Hohlräumen zu ermöglichen.

3. Verfahren nach einem der Ansprüche 1 bis 2, **dadurch gekennzeichnet, dass** das Verfahren zwischen den Schritten b) und d) einen Schritt des Anwendens c) eines Wärmebudgets zum Glühen der Verbindung umfasst.

4. Verfahren nach Anspruch 3, **dadurch gekennzeichnet, dass** das Anwenden des Wärmebudgets nach Schritt c) außerdem einen Schritt c1) des Anwendens eines Drucks auf beide Seiten einer Verbindungsschnittstelle (6) umfasst.

5. Verfahren nach einem der Ansprüche 1 bis 4, **dadurch gekennzeichnet, dass** der Schritt d) des Eintauchens das Erhitzen des oxidierenden Fluids (8) insbesondere auf eine Temperatur ungefähr im Bereich zwischen 10 °C und 100 °C umfasst.

6. Verfahren nach einem der Ansprüche 1 bis 5, **dadurch gekennzeichnet, dass** das Verfahren nach Schritt d) einen Schritt e) des Anwendens einer thermischen Behandlung der Verstärkung der Verbindung umfasst.

7. Verfahren nach einem der Ansprüche 3 bis 6, **dadurch gekennzeichnet, dass** die Anwendung des Wärmebudgets nach Schritt c) bei einer Temperatur, die im Bereich zwischen 30 °C und 400 °C liegt, und vorzugsweise bei einer Temperatur, die kleiner als oder gleich 250 °C beträgt, und noch bevorzugter bei einer Temperatur, die im Bereich zwischen 50 °C und 200 °C liegt, während eines Zeitraums, der zwischen einigen zehntel Minuten und mehreren Stunden liegt, durchgeführt wird.

8. Struktur (100), aufweisend eine vertikale elektrische Leitfähigkeit und umfassend eine Stapelung, die sukzessiv Folgendes umfasst
- ein erstes Substrat (1) aus einem halbleitfähigen Material,
- eine erste Metallschicht (2),
- eine zweite Metallschicht (4), die direkt an die erste Metallschicht (2) durch eine direkte Verbindung verbunden ist, um eine elektrisch leitfähige Verbindungsschnittstelle (6) zu bilden, und
- ein zweites Substrat (3) aus einem halbleitfähigen Material,
wobei die erste Metallschicht (2) die Gesamtheit einer Fläche des ersten Substrats (1) abdeckt, wobei die zweite Metallschicht (4) die Gesamtheit einer Fläche des zweiten Substrats (3) abdeckt, wobei die Rauigkeit der ersten Metallschicht (2) und die Rauigkeit der zweiten Metallschicht (4) kleiner als 50 nm RMS ist, und das Metall der ersten Metallschicht (2) und das Metall der zweiten Metallschicht (4) ausgewählt ist aus Kupfer, Molybdän, Wolfram und ihren Legierungen, und
die Verbindungsschnittstelle (6) umfasst
Metallmaterialbrücken (5) zwischen der ersten Metallschicht (2) und der zweiten Metallschicht (4), wobei die Metallbrücken (5) durch Hohlräume beabstandet sind,
wobei ein Metalloxyd, erzeugt durch die Oxydation der Abschnitte der ersten Metallschicht (2) und der zweiten Metallschicht (4) die die Hohlräume begrenzen, mindestens teilweise die Hohlräume ausfüllt, wobei das Metalloxid Kontaktbereiche (9) zwischen den Abschnitten der ersten Metallschicht (2) und der zweiten Metallschicht (4) bildet, die die Hohlräume begrenzen, bildet.

9. Struktur (100) nach Anspruch 8, **dadurch gekennzeichnet, dass** mindestens 50 % der Hohlräume, die teilweise vom Metalloxyd ausgefüllt sind, eine Abmessung von weniger als oder gleich wie 50 Nanometer aufweisen.

## Claims

1. A method for making a conductive metal direct bonding between two substrates (1, 3) of semiconductor materials, comprising the steps consisting in:
- a) Providing a first substrate (1), the entire surface of which is covered by a first metal layer (2) and a second substrate (3), the entire surface of which is covered by a second metal layer (4), the roughness of the first metal layer (2) and the roughness of the second metal layer (4) being less than 50 nm RMS, the metal of the first metal layer (2) and the metal of the second metal layer (4) are selected from copper, molybdenum, tungsten and the alloys thereof,
- b) Setting the first metal layer (2) and the second metal layer (4) in direct contact so as to form a bonding interface (6) comprising metal material bridges (5) between the first metal layer (2) and the second metal layer (4), the material bridges (5) being spaced by cavities fluidly connected to each other,
- d) After step b), immersing the bonding interface (6) in an oxidizing liquid (8) selected from liquid water (H2O) and hydrogen peroxide (H2O2), so as to oxidize at least partially portions of the first metal layer (2) and portions of the second metal layer (4) delimiting the cavities, this oxidation generating a metal oxide at least partially filling the cavities, the metal oxide forming contact areas (9) between the portions of the first metal layer (2) and the second metal layer (4) delimiting the cavities.

2. The making method according to claim 1, **characterized in that** the immersion step d) is carried out for a duration comprised between about 30 minutes and several hours so as to enable the penetration of the oxidizing fluid (8) and the growth of the metal oxide in the cavities.

3. The making method according to any of claims 1 to 2, **characterized in that** the method comprises between steps b) and d) a step c) of applying a bonding annealing thermal budget.

4. The making method according to claim 3, **characterized in that** the application of the thermal budget according to step c) further comprises a step c1) of applying a pressure on either side of the bonding interface (6).

5. The making method according to any of claims 1 to 4, **characterized in that** the immersion step d) comprises heating the oxidizing fluid (8) in particular to a temperature comprised between about 10°C and 100°C.

6. The making method according to any of claims 1 to 5, **characterized in that** the method comprises after step d) a step e) of applying a bonding reinforcement thermal treatment.

7. The making method according to any of claims 3 to 6, **characterized in that** the application of the thermal budget according to step c) is carried out at a temperature comprised between 30°C and 400°C and preferably at a temperature lower than or equal to 250°C and more preferably at a temperature comprised between 50°C and 200°C, for a duration comprised between a few tens of minutes and several hours.

8. A structure (100) having a vertical electrical conductivity and comprising a stack including successively
- a first substrate (1) of a semiconductor material,
- a first metal layer (2),
- a second metal layer (4) bonded directly to the first metal layer (2) by direct bonding so as to form an electrically-conductive bonding interface (6), and
- a second substrate (3) of a semiconductor material,
the first metal layer (2) covering the entirety of a surface of the first substrate (1), the second metal layer (4) covering the entirety of a surface of the second substrate (3), the roughness of the first metal layer (2) and the roughness of the second metal layer (4) being less than 50 nm RMS and the metal of the first metal layer (2) and the metal of the second metal layer (4) being selected from copper, molybdenum, tungsten and the alloys thereof, and
the bonding interface (6) comprising
metal material bridges (5) between the first metal layer (2) and the second metal layer (4), the material bridges (5) being spaced by cavities,
a metal oxide, generated by the oxidation of the portions of the first metal layer (2) and the second metal layer (4) delimiting the cavities, at least partially filling the cavities, the metal oxide forming contact areas (9) between the portions of the first metal layer (2) and the second metal layer (4) delimiting the cavities.

9. The structure (100) according to claim 8, **characterized in that** at least 50% of the cavities partially filled by the metal oxide have a size smaller than or equal to 50 nanometers.
